# EUROPEAN PATENT SPECIFICATION

(11) **EP 0 332 680 B1**
(45) Date of publication and mention of the grant of the patent: **01.12.1993**
(21) Application number: 88908021.4
(22) Date of filing: 10.08.1988
(51) Int. Cl.: H01L 21/28, H01L 21/00

(54) **PROCESS OF FORMING A T-GATE METAL STRUCTURE ON A SUBSTRATE**
VERFAHREN ZUR HERSTELLUNG EINER T-GATE METALLSTRUKTUR AUF EINEM SUBSTRAT
PROCEDE DE FABRICATION D'UNE STRUCTURE DE GRILLE EN T EN METAL SUR UN SUBSTRAT

(30) Priority: 14.09.1987 US 95968
(43) Date of publication of application: 20.09.1989
(73) Proprietor: Hughes Aircraft Company, Los Angeles, California 90045-0066 (US)
(72) Inventor: NGO, Catherine, Woodland Hills, CA 91367 (US); BEAUBIEN, Randall, S., Westlake Village, CA 91361 (US); ERPS, Lorri, Fresno, CA 93704 (US)
(74) Representative: KUHNEN, WACKER & PARTNER
(86) International application number: US8802766
(87) International publication number: WO8902652

(56) References cited:
- US-A- 4 575 402
- IEEE Transactions on Electron Devices, volume ED-32, no. 6, June 1985, IEEE New York, US, P.C. Chao et al.: "Electron-beam fabrication of GaAs low-noise MESFET's using a new trilayer resist technique", pages 1042-1046
- IBM Technical Disclosure Bulletin, volume 28, no 11, April 1986, (New York, US), "Dyed resist to enhance undercut angles attainable on reduction projection printers", pages 4805-4806
- Journal of Vacuum Science & Technology B, volume 4, no. 5, September/October 1986, Second Series, American Vacuum Society, (New York, US), L. Myers et al.: "Improvement in resolution and reproducibility using the polymethylmethacrylate/polymethylacrylic acid bilayer system", pages 1259-1260

## Description

### BACKGROUND OF THE INVENTION

This invention relates to a process for preparing a T-gate metal structure on a substrate. In particular, this invention relates to the fabrication of semiconductor transistors and gate electrodes for field effect transistors.

From IEEE Transactions on electron devices, vol. ED-32, No. 6, June 1985, pages 1042-1046, electron-beam fabrication of GaAs low-noise MESFET's using a trilayer resist technique is known. With this resist system, sub-half-micrometer T-shaped cross section metal lines are produced using e-beam lithography. The system provides T-shaped resist cavities with undercut profiles. T-shaped metal lines as narrow as 0.15 µm have been produced.

Semiconductor transistors are found in nearly all electronic devices. They can be made in miniature forms useful in integrated circuits and other electronic packages of reduced size. The introduction of the transistor and its continuing development in ever-smaller forms is one of the major factors in the growth of popularity of consumer devices such as hand-held calculators and personal computers, and in sophisticated business and military electronics systems.

The operation of the small-scale transistors is generally understood from the point of theory, but it remains to develop the fabrication techniques for constructing the devices reproducibly and reliably, on a commercial basis. As the size of the transistors is reduced, many of the fabrication techniques routinely employed in preparing larger devices cannot be used because they reach some inherent physical limitation. For example, ultraviolet light/photoresist techniques used to fabricate larger transistors cannot be used in the same form for devices of less than a micrometer in size due to limitations imposed by optical effects. Well known fabrication techniques therefore may become obsolete as further size reductions are achieved. The effort to achieve further miniaturization is therefore closely linked to the development of processes for preparing the desired structures.

One important type of transistor is the field effect transistor, of which there are a number of varieties. The metal-semiconductor field effect transistor, or MESFET, is a voltage controlled variable resistor. A controllable electrical current is established between source and drain electrodes of the MESFET, with the current controlled by a voltage applied to a gate electrode that is positioned on the semiconductor substrate between the source and drain electrodes.

Field effect transistors can be fabricated from many types of semiconductor materials. Gallium arsenide is a semiconductor having excellent properties for use at high frequencies. Gallium arsenide MESFETs are of particular interest for use in electronic circuits for low-noise amplification of signals, high-efficiency power generation, and high-speed logic functions, among others. Investigations directed at reducing the size of gallium arsenide MESFETs for use in integrated circuits and other applications are ongoing.

The performance of MESFETs is determined in part by the dimensions, electrical resistance, and capacitance of the gate electrode. Higher resistance and capacitance of the gate electrode are undesirable, because they reduce the high frequency performance of the MESFET in devices and circuits. As the length of the contact surface or gate length of the electrode parallel to the direction of current flow is reduced, the resistance of the gate increases (for a particular gate metal thickness) and its capacitance decreases. That is, as the gate length is made shorter, its resistance rises and becomes the dominant factor in limiting the operating frequency of the MESFET. As the size of MESFETs is reduced, the necessary reduction in the size of the gate can therefore limit its performance and effectively prevent further reduction in size.

Various geometrical arrangements and related techniques for preparing the gate electrode have been proposed, with the result that the minimum gate length has been reduced to about 0.25 micrometers in the current art. One approach to preparing such short gates, having acceptably low electrical resistance and capacitance, has been to prepare the gate with a cross sectional profile in the shape of the letter "T", with the short foot at the bottom of the T contacting the semiconductor substrate to provide a short contact length for reduced capacitance, and the head at the top of the T having more metal to lower resistance.

The fabrication of a metal structure of the T shape, in the small sizes required, is difficult and demanding, because the enlarged size of the head inherently tends to result in continuity between metal in the T and metal on the surface of the polymer resist layer that is removed during the lift-off stage of fabrication. Such continuity results in the T-gate being destroyed when the polymer resist system is dissolved during the metal lift-off process. It is therefore necessary in the design of the fabrication process to avoid any possibility of a continuous metal film between the T structure and the overlying deposited metal.

T-gates of 0.25 micrometer and even shorter lengths cannot be fabricated using conventional ultraviolet light lithographic techniques. Instead, it is necessary to prepare them by focused beam techniques such as electron beam lithography. While such focused beam techniques are operable, they have the important disadvantage that gates must be fabricated one at a time by the programmed electron beam writing unit, into sensitized polymer layers previously deposited upon the substrate, which are then developed prior to metallization of the surface. This serial (step and repeat) fabrication process is slow, reducing the production rate of devices having T-gates. The patterning with the focused electron beam is accomplished in a large, expensive machine. Where the circuit on a chip contains hundreds of MESFETs, the overall production rate is slow and requires a large capital expenditure for one or more focused electron beam units.

It is, of course, of interest to increase the producibility and reduce the capital expenditures required to fabricate devices containing small T-gate electrodes, while retaining the small size and reaching even smaller sizes. No mass production technique has as yet been proposed, where the technique achieves high quality devices at a rapid rate and satisfactorily small capital costs. Accordingly, there exists a need for a gate electrode fabrication technique permitting the commercial-scale fabrication of small T-gates for use in field effect transistors and possibly other electronic devices. The present invention according to claim 1 fulfills this need, and further provides related advantages.

### SUMMARY OF THE INVENTION

The present invention is embodied in a multistep process for fabricating electrodes for semiconductor devices, and particularly for fabricating T-gate electrodes for field effect transistors. The process uses optical flood illumination in conjunction with a new arrangement of known photoresist materials, to define the openings into which metal is deposited. The use of flood illumination permits the simultaneous definition of many gates on a wafer, without the use of expensive focused electron beam apparatus or ion beam apparatus. Very small gate lengths as low as about 0.25 micrometers or less can be achieved, equalling the state of the art at the present time. The process can be practiced with individual steps and materials that are known in the art and are reliable, and is fully compatible with related processing of field effect transistors and other circuit elements.

A process for preparing a T-gate metal structure on a substrate comprises the steps of depositing over the substrate a first layer of a positive photoresist polymer material that is photosensitive to deep ultraviolet light and is developed in a first solvent; depositing over the first layer a second layer of a positive photoresist polymer material that is photosensitive to deep ultraviolet light and is developed in a second solvent; depositing over the second layer a third layer of a positive photoresist polymer material that is photosensitive to deep ultraviolet light and is developed in a solvent which is different from that used to develop the second layer; depositing over the third layer a fourth layer of a photoresist polymer material that is photosensitive to mid-range ultraviolet light; exposing a stripe in the fourth layer using mid-range ultraviolet light and developing the stripe in the fourth layer, producing an opening through the fourth layer to the upper surface of the third layer; exposing a pattern in the first, second, and third layers through the opening in the fourth layer using the fourth layer as a mask, with deep ultraviolet light; sequentially developing the pattern in the third layer, the second layer, and the first layer to produce an opening through the third, second, and first layers to the substrate, thereby producing a patterned substrate; and depositing metal downwardly onto the patterned substrate. This metallization is then usually followed by the step of removing the remaining portion of the polymer layers, thereby removing the excess deposited metal, to complete the T-gate.

The T-gate electrode gate structure permits a short contact length between the foot or downwardly extending central portion of the T, and the surface of the semiconductor. This contact length forms the gate for the field effect transistor, which can be made reproducibly with the short length. The head or cross piece of the T contains a larger volume of metal than might be otherwise expected for the short gate length, thereby decreasing the electrical resistance of the T-gate electrode.

The first, second, and third layers are formed by successively applying three layers of photoresist materials over the substrate, which is normally a semiconductor previously prepared with an input electrode, an output electrode, and a channel region therebetween as the basis for a field effect transistor. In large scale production, there may be dozens or hundreds of such transistors on a single chip. The photoresist materials of the first, second, and third layers are photosensitive to deep ultraviolet light having a wavelength of less than about 300 nanometers, and preferably having a peak absorbtion wavelength of about 220 nanometers. The photoresist material used in the second layer is developed in a solvent different from that used to develop the first layer and that used to develop the third layer, so that the three layers can be later developed sequentially. The preferred polymers for these three layers are poly(methyl methacrylate), or PMMA, for the first layer, a copolymer of polymethacrylic acid in poly(methyl methacrylate) for the second layer, and poly(methyl methacrylate) for the third layer.

The material of the fourth layer differs in that it is a photoresist polymer that is sensitive to ultraviolet light in the middle range of wavelengths, as from about 350 to about 450 nanometers, preferably about 400 nanometers. The material of the fourth layer is not sensitive to the same range of wavelengths as are the materials of the first, second, and third layers. The fourth layer can therefore be patterned without affecting the underlying layers, and the underlying layers can be patterned using the fourth layer as a mask. The material of the fourth layer is preferably, but not necessarily, a positive photoresist wherein the chemical structure of the exposed region is altered so as to be removed in layer developing. The material of the fourth layer is preferably a positive photoresist such as a napthoquinone diazide compound of the type available commercially as Kodak 809 photoresist.

The materials used in the four individual layers are prepared according to conventional practice for each such material. The procedure typically involves dissolving the photoresist polymer material in a spin casting solvent. The layers are applied by any appropriate technique, preferably spin casting, to the desired thickness. To achieve 0.25 micrometer linewidths, the thickness of the layers are typically about 0.3 micrometers for the first layer, 0.3 micrometers for the second layer, 0.2 micrometers for the third layer, and 0.5 micrometers for the fourth layer.

Patterning of the substrate begins with exposing and developing a stripe in the fourth layer, directly above the point on the substrate where the foot of the T-gate is desired. To produce a foot having a gate length of about 0.25 micrometers, the stripe is about 0.5 to about 0.8 micrometers wide. The length is as required, but is typically about 75 micrometers for gallium arsenide field effect transistors. The stripe is exposed through a mask positioned above the surface, using mid-range ultraviolet light that causes a chemical change in the exposed region of the fourth layer but largely has no effect on the underlying first, second, and third layers. The stripe is developed in an appropriate solvent for the polymer of the fourth layer, removing the exposed portion (where a positive photoresist is used) of the polymer. The result is an opening through the fourth layer to the third layer, the opening having the shape of the exposed stripe.

Pattern transfer into the first, second, and third layers through the opening in the fourth layer is accomplished by deep ultraviolet flood exposure of the wafer, using the fourth layer as a conformal mask. The pattern can be controlled precisely, since the conformal mask is fixedly positioned relative to these layers. The pattern is exposed with deep ultraviolet light, which causes a chemical change in the exposed portion of the first, second, and third layers, but has little effect on the fourth layer.

When the first, second, and third layers are exposed through a conformal mask, the width of the exposed region in the first layer (adjacent to the substrate surface) is less than the width of the stripe opening in the fourth layer conformal mask. The width of the exposed region in the second layer is greater than that of the first region, and greater than that of the stripe opening in the fourth layer conformal mask. The width of the exposed region in the third layer is usually intermediate between that of the second region and the width of the stripe opening in the fourth layer. The exposed region in the first, second, and third layers is therefore somewhat bulbous in cross section, with a foot in contact with the substrate of less width than the stripe opening in the fourth layer.

The pattern in the first, second, and third layers is developed sequentially beginning with the third layer. The sequential developing is permitted by the selection of the polymer material in the second layer to be such that it develops in a different solvent than the polymer materials in the first and third layers. The exposed substrate is dipped in or sprayed with a solvent that dissolves the exposed polymer of the third layer, optionally rinsed with a nonsolvent, dipped in or sprayed with a solvent that dissolves the exposed polymer of the second layer, optionally rinsed with a nonsolvent, dipped in or sprayed with a solvent that dissolves the exposed polymer of the first layer, and rinsed with a nonsolvent. The result is a patterned composite overlay having a bulbous cross sectional shape, formed in the overlying layers of polymer material. Patterning of the substrate is complete.

Metal is then deposited downwardly onto the substrate to form the T-gate electrode. The metal deposits into the opening defined in the preceding steps, and also generally onto the top surface of the resist structure. Within the open pattern, the metal deposits directly onto the substrate to a width determined by the width of the first layer. This width, which is less than the width of the stripe opening in the fourth layer, defines the foot or gate length of the T-gate. Since the width of the opening in the second layer is greater than that of the first layer, the portion of the T-gate above the foot forms an enlarged head as metal is deposited therein.

The backwardly sloped or reentrant portion of the opening between the second and third layers defines a separation between the metal of the T-gate head and that deposited upon the surface of the overlying resist structure. This separation is necessary for a clean removal of the unwanted portion of the deposited metal in the subsequent lift-off step. The metal used in the metallization can be any metal appropriate to the materials used in the field effect transistor. For gallium arsenide MESFETs, the preferred metallization is a three-layer system of titanium, platinum, and gold. The thickness of the metallization is chosen to be less than the total thickness of the first, second, and third layers, and is about 0.75 micrometers for the most preferred structure.

The polymer resist structure (first, second, third, and fourth layers, although the fourth layer may have been optionally removed prior to this step), along with the overlying metal deposited on top of the resist structure, is removed in a lift-off procedure. The substrate is immersed in a solvent that dissolves the remaining polymer layers, or a sufficient portion of them to remove the polymer layers from the surface of the substrate. The metallic T-gate remains on the surface of the substrate. The substrate can then be further processes as necessary.

The resulting field effect transistor is made without the need to expose the materials therein to focused electron beams, and in a less expensive fashion using only flood exposure techniques. This approach permits substrates having a plurality of field effect transistors thereon to be made much more economically than by a focused charged beam approach.

Thus, in a preferred embodiment, a process for preparing a T-gate metal structure for use in a semiconductor device, the T-gate having a foot in contact with a semiconductor substrate and an enlarged head upon the foot and integral therewith, comprises the steps of depositing onto the substrate a first layer of poly(methyl methacrylate) having a thickness of about 0.3 micrometers; depositing over the first layer a second layer of a copolymer of polymethacrylic acid and poly(methyl methacrylate) having a thickness of about 0.3 micrometers; depositing over the second layer a third layer of poly(methyl methacrylate) having a thickness of about 0.2 micrometers; depositing over the third layer a fourth layer of a polymer material that is photosensitive to ultraviolet light having a wavelength of about 400 nanometers; exposing a stripe of about 0.5 to about 0.8 micrometers width in the fourth layer using ultraviolet light having a wavelength of about 400 nanometers and developing the exposed region, producing an opening having a width of about 0.5 to about 0.8 micrometers through the fourth layer and revealing the upper surface of the third layer; exposing a pattern in the first, second, and third layers through the opening in the fourth layer, using the fourth layer as a mask, with ultraviolet light having a wavelength of about 220 nanometers, the width of the pattern in the first layer being less than the width of the opening through the fourth layer and less than the width of the pattern in the second layer; sequentially developing the pattern in the third layer, the second layer, and the first layer to produce an opening through the third, second, and first layers to the substrate; and metallizing the developed pattern to produce a T-gate having a foot with the width of the pattern in the first layer and a head of greater width. The remaining material in the polymer layers, and the overlying metallization not a part of the T-gate, are then removed by lift-off methods. Most preferably, the process just described is used to make a plurality of T-gates on a substrate having multiple field effect transistors therein, the gates being formed simultaneously.

It will now be appreciated that the process of the invention, and the T-gates and field effect transistors made thereby, provide an important advance in the art of integrated circuit fabrication. T-gates with gate lengths of 0.25 micrometers or less are made by flood illumination techniques using ultraviolet light, whereby large numbers of T-gates on one or several substrate chips can be made simultaneously. There is no need for expensive focused electron beam apparatus. Instead, low cost, commonly available optical systems are employed. That is, the present technique is particularly suited for mass production of integrated circuits having large numbers of field effect transistors requiring short gate lengths. Other features and advantages of the present invention will be apparent from the following more detailed description, taken in conjunction with the accompanying drawings, which illustrate, by way of example, the principles of the invention.

### BRIEF DESCRIPTION OF THE DRAWINGS

Figure 1 is a side elevational view of a field effect transistor having a T-gate;
Figures 2A-J is a pictorial process flow diagram of the preferred process of the invention, illustrating the structure obtained at each stage; and
Figure 3 is a side elevational view of the structure of Figure 2D, illustrating the spatial intensity of the diffracted beam of deep ultraviolet light.

### DETAILED DESCRIPTION OF THE PREFERRED EMBODIMENT

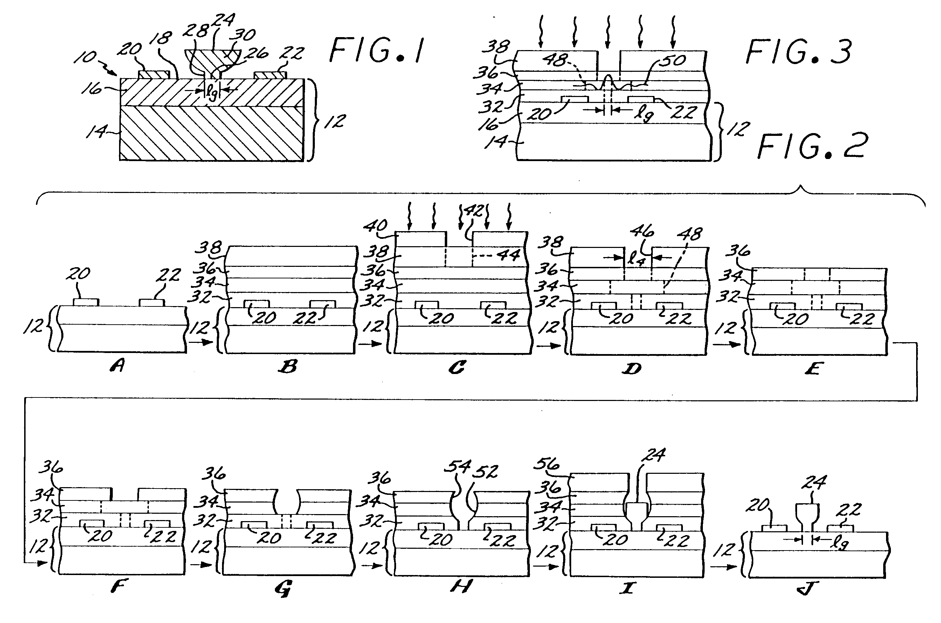

By way of background, Figure 1 illustrates an enhancement-mode gallium arsenide MESFET 10 of the type fabricated in part with a preferred embodiment of the invention. The MESFET 10 includes a substrate 12 having a base 14 of gallium arsenide single crystal and a doped layer 16 of gallium arsenide overlying the base 14. The doped layer 16 can be n-doped or p-doped.

Three electrodes are contacted to an upper surface 18 of the substrate 12. A source electrode 20 and a drain electrode 22 are deposited some distance apart. A gate electrode, here illustrated as a T-gate electrode 24 of the invention, is positioned between the source electrode 20 and the drain electrode 22. The T-gate electrode 24 contacts the substrate 12 along a surface that is the gate 26, and the contact length is defined as the gate length l_{g}. The downwardly extending portion of the T, having a lateral dimension of l_{g}, is termed a foot 28 of the T-gate electrode 24. The cross piece of the T, which in reality is shaped somewhat like the head of a mushroom, is termed a head 30.

Figure 2 schematically illustrates the preferred embodiment of the process of the invention. The starting point for the preparation of the T-gate electrode 24 is the substrate 12, which is typically furnished with the source electrode 20 and the drain electrode 22 already in place, as illustrated in Figure 2A.

A first layer 32 is deposited overlying the upper surface 18 of the substrate 12, a second layer 34 is deposited overlying the first layer 32, a third layer 36 is deposited overlying the second layer 34, and a fourth layer 38 is deposited overlying the third layer 36, resulting in the structure illustrated in Figure 2B. The layers 32, 34, 36, and 36 are preferably applied by spin casting, wherein the respective layer materials are dissolved in a spin casting solvent, the solution is applied to the surface to be covered, and the surface is rotated to distribute the solution uniformly over the surface. After application, the solvent is evaporated from the solution, leaving the solute material forming the layer. Each layer is typically baked at elevated temperature to cure the resist layer, remove all traces of the spin casting solvent, and prevent interdiffusion of the portion of each layer in contact with the spin casting solvent of the next layer.

In the preferred embodiment, the first layer 32 is prepared from a 4 percent solution of poly(methyl methacrylate) in the spin casting solvent chlorobenzene (this solution is termed "PMMA solution" herein). A sufficient amount of this PMMA solution is placed onto the surface of the substrate 12 to form a solid first layer 32 about 0.3 micrometers thick, after curing. The substrate is spun at a rate of 2500 revolutions per minute (rpm) to distribute the solution evenly over the surface. The coated substrate 12 is then baked at a temperature of 180°C for 30 minutes, and cooled at ambient temperature for 5 minutes.

The second layer 34 is prepared from a copolymer solution of 10 percent polymethacrylic acid in the PMMA solution whose preparation was previously described. A sufficient amount of this solution is placed onto the substrate 12 (which already has the baked layer 32 in place) to form a solid second layer 34 about 0.3 to 0.35 (preferably 0.34) micrometers thick, after evaporation of the casting solvent. The substrate is spun at a rate of 2000 rpm to distribute the solution evenly over the surface. The coated substrate 12 is then baked at a temperature of 125°C for 20 minutes and cooled at ambient temperature for 5 minutes.

The third layer 36 is prepared from the same PMMA solution whose preparation was described previously in relation to the first layer 32. A sufficient amount of this solution is placed onto the substrate 12 (which already has the baked layers 32 and 34 in place) to form a solid third layer 36 about 0.2 micrometers thick, after evaporation. The substrate is spun at a rate of 6000 rpm to distribute the solution evenly over the surface. The coated substrate 12 is then baked at a temperature of 180°C for 20 minutes and cooled at ambient temperature for 5 minutes.

The fourth (sometimes also termed the "top") layer 38 is prepared from a positive photoresist material sensitive to mid-range ultraviolet light, such as the napthoquinone diazide compound available commercially as Kodak 809 photoresist. A sufficient amount of this solution is placed onto the substrate 12 (which already has the baked layers 32, 34, and 36 in place) to form a solid fourth layer 38 about 0.5 micrometers thick, after evaporation. The substrate is spun at a rate of 3000 rpm to distribute the solution evenly over the surface. The substrate 12 is then baked for 30 minutes at a temperature of 90°C and cooled to ambient temperature for 5 minutes.

The substrate 12 is thereby coated with the layers 32, 34, 36, and 38, and is ready for pattern exposure and development, and metallization.

A separate, external glass mask 40 having an opening 42 therethrough is placed over the top of the fourth layer 38 in a contact printer (mask aligner), and a flood exposure of ultraviolet light of wavelength 400 nanometers is directed downwardly against the upper surface of the fourth layer 38, see Figure 3C. The opening 42 is preferably rectangular, with a width of about 0.4 to about 0.6 micrometers, and a length as needed. An exposure region 44 in the fourth layer 38 is therefore a rectangular stripe, when viewed from above. The underlying first layer 32, second layer 34, and third layer 36 have essentially no sensitivity to ultraviolet light in this wavelength range, and are therefore substantially unaffected by this exposure. The mask 40 is opaque to ultraviolet light, so that the fourth layer 38 is exposed in the region under the opening 42, but unexposed under the opaque portions of the mask 40. Exposure is at a dosage of 20 milliwatts per square centimeter for 5 seconds. The external mask 40 is removed, and the fourth layer 38 is developed for one minute in a mixture of 1 part of Kodak 809 developer in 4 parts water. The Kodak 809 polymer is a positive photoresist, so that the exposed portion of the fourth layer 38, under the opening 42, is soluble in, and removed by, the solvent developer to form an opening 46 in the fourth layer 38, having the same size and dimensions as the opening 42, and in particular a width l₄ corresponding to that defined by the mask 40. The surface is rinsed for 2 minutes in deionized water and dried in nitrogen.

A pattern 48 is exposed in the first layer 32, the second layer 34, and the third layer 36 by deep ultraviolet light having a wavelength of about 220 nanometers. (As used herein, mid-range ultraviolet light has a wavelength of from about 350 to about 450 nanometers, and deep ultraviolet light has a wavelength of less than about 300 nanometers.) The fourth layer 38, with the opening 46 therethrough, acts as a conformal mask adhered to the upper surface of the third layer 36, during this exposure. The conformal mask results in a precisely defined pattern 48, because the lateral and vertical position of the mask is fixed with respect to the layers 32, 34, and 36. The preferred exposure is a light intensity of 15 milliwatts per square centimeter, for 3 minutes. The exposure process is illustrated in Figure 2D, and the general shape of the pattern 48 is illustrated by the dashed lines in Figures 2D and 3.

The shape of the exposure pattern 48 may be inferred from the final shape of the T-gate electrode 24. The width of the pattern 48 in the third layer 36 is essentially equal to that of the opening 46, l₄. The width of the pattern 48 in the second layer 34 is greater than l₄, and the width of the pattern 48 in the first layer 32 is less than l₄. While not wishing to be limited to this possible explanation, it is believed that the greater width of the pattern 48 in the second layer 34, and the lesser width of the pattern 48 in the first layer 32, are due to the diffraction of the deep ultraviolet light as it passes through the opening 46 in the conformal mask formed by the fourth layer 38. The width of this opening 46 is about 2-3 times the wavelength of the light, resulting in a diffraction pattern 50 of the form illustrated schematically in Figure 3. The side lobes of the diffraction pattern 50 are most pronounced in the region of the second layer 34, resulting in an effective broadening of the exposure pattern 48 in this region. These side lobes are greatly diminished in the first layer 32, with the result that only the light energy in the narrow central peak region of the diffraction pattern 50 causes exposure of the first layer 32. Since the central peak is considerably narrower than l₄, the exposed region in the first layer 32 is also less than l₄. This region becomes the foot 28 of the completed T-gate electrode 24, and its width corresponds to the gate length l_{g}, which is less than the width of the stripe l₄. It is believed that this diffraction of light is responsible for the shape of the final T-gate electrode 24, but, even if not, the fact remains that the results described herein are obtained.

After the pattern 48 is defined, the fourth layer 38 is usually removed by dissolution in methyl isobutyl ketone (MIBK). This removal, illustrated in Figure 2E, is incidental and may be omitted.

The layers 36, 34, and 32 are developed to remove the material within the exposed pattern 48, inasmuch as the resist materials used in each of these layers are positive photoresists. The developing process is accomplished sequentially, so that the third layer 36 is developed, the second layer 34 is developed, and finally the first layer 32 is developed. It has been observed that this sequential development process, together with the use of three separate layers 32, 34, and 36, yields a controllable pattern structure having the necessary characteristics to be described.

The portion of the pattern 48 lying within the third layer 36 is developed by flood immersing the exposed substrate into methyl isobutyl ketone for 1 minute, which dissolves the exposed portion of the layer 36 (Figure 2F) and removes the Kodak 809 photoresist. The portion of the pattern 48 lying within the second layer 34 is then developed by flood immersing the exposed substrate into 2-ethoxyethyl (cellosolve) for 1 minute, which dissolves the exposed portion of the layer 34 (Figure 2G). The portion of the pattern 48 lying within the first layer 32 is developed by flood immersing the exposed substrate into methyl isobutyl ketone for 1 minute, which dissolves the exposed portion of the layer 32 (Figure 2H). The developed substrate is rinsed in isopropanol for 30 seconds and deionized water for 2 minutes, and blown dry.

The developing process results in an opening 52 through the layers 32, 34, and 36, to the upper surface 18 of the substrate 12. Figure 2H illustrates the bulbous cross sectional shape of this opening 52. The opening is generally narrow and straight-sided in the first layer 32, angular outwardly so as to enlarge the width of the opening 52 in the second layer 34 (when considered from the perspective of passing upwardly from the first layer 32 into the second layer 34), and angular inwardly at a location 54 so as to reduce the size of the opening 52 in the third layer 36. The reentrant character of the opening 52 in the third layer 36 is important, as it causes a metal separation in the metallization step.

The T-gate electrode 24 is formed by depositing a metallic layer 56 downwardly upon the substrate 12 in a process termed metallization. The metal is deposited by any suitable process, such as vapor deposition. The preferred metal for use in T-gate electrodes is a trilayer of titanium, platinum, and gold. The metallic layer 56 is deposited to be a suitable thickness, preferably about 0.75 micrometers. The resulting structure is illustrated in Figure 2I. The metal deposited on top of the third layer 36 forms the flat, extensive metallic layer 56. The metal which passes into the opening 52 deposits on those surfaces visible from above in a line of sight to form the T-gate electrode 24. The metal deposits onto the surface 18 of the substrate 12, in the portion of the opening 52 within the first layer 32, forming the foot 28 of the T-gate electrode 24. The metal also deposits on a portion of the outwardly sloping walls of the opening 52 within the second layer 34. However, as illustrated in Figure 2I, the metal cannot deposit onto the reentrant portion in the neighborhood of the location 54, because it slopes backwardly and is shielded by the portion of the third layer 36 that overhangs it. The metal in the T-gate electrode 24 is thereby separated from the metal on the top layer 56, so that the metal layer 56 can be later removed.

The metal layer 56 is removed, along with the remaining portions of the first layer 32, second layer 34, and third layer 36, by a lift off process, the results of which are illustrated in Figure 2J. The lift-off process is accomplished by immersing the substrate 12 and the structure built thereupon into a solvent which dissolves the polymer materials in the layers 32, 34, and 36. In the preferred process, the layers 32, 34, and 36, together with the separated metallic layer 56, are lifted off by immersing the substrate, in an inverted position, in acetone for 10 minutes.

The final T-gate field effect transistor 10 is illustrated in Figure 2J. It will be appreciated that the process of the invention, and as just described, is particularly suited to simultaneous deposition of large numbers of these structures all located within the same plane of the integrated circuit. The mask 40 need only be provided with proper openings 42 centered above each of the field effect transistors 10 in the plane, so that the process results in simultaneous deposition of the necessary number of T-gate electrodes 24.

The following example illustrates aspects of the invention, and should not be taken as limiting of the invention in any respect.

### Example 1

A T-gate having a gate length l_{g} of 0.25 micrometers and a maximum width of the gate of about 200 micrometers was prepared with the preferred embodiment of the process, as just described.

It will now be appreciated that the process of the invention provides an important advance in the art of fabricating T-gates for field effect transistors.

## Claims

1. A process of forming a T-gate metal structure on a substrate (12), comprising the steps of:
depositing over the substrate (12) a first layer (32) of a positive photoresist polymer material that is photosensitive to deep ultraviolet light and is developed in a first developer;
depositing over the first layer (32) a second layer (34) of a positive photoresist polymer material that is photosensitive to deep ultraviolet light and is developed in a second developer;
depositing over the second layer (34) a third layer (36) of a positive photoresist polymer material that is photosensitive to deep ultraviolet light and is developed in a developer which is different from said second developer;
depositing over the third layer (36) a fourth layer (38) of a photoresist polymer material that is photosensitive to mid-range ultraviolet light;
exposing a strip in the fourth layer (38) using mid-range ultraviolet light and developing the strip in the fourth layer (38), producing an opening (46) through the fourth layer (38) the upper surface of the third layer (36);
exposing a pattern (48) in the first, second, and third layers (32,34,36) through the opening (46) in the fourth layer (38) using the fourth layer (38) as a mask, with deep ultraviolet light, the width of the pattern (48) in the third layer (36) being essentially equal to the width (l₄) of the opening (46), the width of the pattern (48) in the second layer (34) being greater than the width (l₄) of the opening (46), the width of the pattern (48) in the first layer (32) being less than the width (l₄) of the opening (46);
sequentially developing the pattern (48) in the third layer (36), the second layer (34), and the first layer (32) to produce an opening (52) through the third, second, and first layers (32,34,36) to the substrate (12), thereby producing a patterned substrate; and
depositing metal (56) downwardly onto the patterned substrate, thereby forming a T-gate metal structure.

2. The process of claim 1, including, after said step of depositing metal (56), the further step of:
removing the remaining portion of the layers (32,34,36,38) of photoresist polymer material.

3. The process of claim 1 or 2, wherein the photoresist polymer material in the first layer (32) is poly(methyl methacrylate).

4. The process of one of claims 1-3, wherein the photoresist polymer material in the second layer (34) is a copolymer of polymethacrylic acid in poly(methyl methacrylate).

5. The process of one of claims 1-4, wherein the photoresist polymer material in the third layer (36) is poly(methyl methacrylate).

6. The process of one of claims 1-5, wherein the photoresist polymer material of the fourth layer (38) is a positive photoresist material.

7. The process of one of the previous claims, wherein the width of the strip in the fourth layer (38) is from 0.5 to 0.8 micrometers.

8. The process of one of the previous claims, wherein the wavelength of the deep ultraviolet light is about 220 nanometers, and the wavelength of the mid-range ultraviolet light is about 400 nanometers.

9. The process of one of the previous claims, the T-gate metal structure (28) having a foot in contact with said substrate (12) and an enlarged head (30) upon the foot (28) and integral therewith, wherein
said first layer (32) of positive photoresist polymer material is photosensitive to ultraviolet light having a wavelength of less than 300 nanometers and developable in a first developer;
said second layer (34) of positive photoresist polymer material is photosensitive to ultraviolet light having a wavelength of less than 300 nanometers and developable in a second developer;
said third layer (36) of positive photoresist polymer material is photosensitive to ultraviolet light having a wavelength of less than 300 nanometers and developable in a developer different from said second developer;
said fourth layer (38) of photoresist polymer material is photosensitive to ultraviolet light having a wavelength of greater than 350 nanometers;
said step of exposing the strip in the fourth layer (38) is done by using ultraviolet light having a wavelength of greater than 350 nanometers and developing the exposed region, producing said opening (46) having a width (l₄) of less than 0.5 micrometers through the fourth layer (38) and revealing the upper surface of the third layer (36);
said step of exposing said pattern (48) in the first, second, and third layers (32,34,36) through the opening (46) in the fourth layer (38) is done by using the fourth layer (38) as a mask with ultraviolet light having a wavelength of less than 300 nanometers; and
said T-gate metal structure having the foot (28) with the width of the pattern in the first layer (32) and the head (30) of greater width.

10. The process of one of the previous claims, wherein the thickness of the first layer (32) is about 0.3 micrometers, the thickness of the second layer (34) is about 0.3 micrometers, the thickness of the third layer (36) is about 0.2 micrometers, and the thickness of the fourth layer (38) is about 0.5 micrometers.

11. The process of one of the previous claims, wherein the T-gate metal structure is part of a field effect transistor.

12. The process of one of the previous claims, wherein a plurality of T-gate metal structures are prepared simultaneously.

## Patentansprüche

1. Verfahren zur Bildung einer T-Gatemetallstruktur auf einem Substrat (12) mit den Schritten:
Abscheiden oberhalb des Substrates (12) einer ersten Schicht (32) eines Positiv-Fotolack-Polyermaterials, welches für tiefe ultraviolette Strahlung fotoempfindlich ist, und in einem ersten Entwickler entwickelt wird;
Abscheiden oberhalb der ersten Schicht (32) einer zweiten Schicht (34) eines Positiv-Fotolack-Polymermaterials, welches für tiefe ultraviolette Strahlung fotoempfindlich ist, und in einem zweiten Entwickler entwickelt wird;
Abscheiden oberhalb der zweiten Schicht (34) einer dritten Schicht (36) eines Positiv-Fotolack-Polymermaterials, welches für tiefe ultraviolette Strahlung fotoempfindlich ist, und in einem Entwickler entwickelt wird, der unterschiedlich ist von dem zweiten Entwickler;
Abscheiden oberhalb der dritten Schicht (36) einer vierten Schicht (38) eines Positiv-Fotolack-Polymermaterials, welches für ultraviolette Strahlung im mittleren Bereich fotoempfindlich ist;
Belichten eines Streifens in der vierten Schicht (38) unter Verwendung von ultravioletter Strahlung im mittleren Bereich und Entwickeln des Streifens in der vierten Schicht (38), Herstellen einer Öffnung (46) durch die vierte Schicht (38) zu der oberen Oberfläche der dritten Schicht (36);
Belichten einer Strukturierung (48) in der ersten, zweiten und dritten Schichten (32, 34, 36) über die Öffnung (46) in der vierten Schicht (38) unter Verwendung der vierten Schicht (38) als Maske mit tiefer ultravioletter Strahlung, wobei die Breite der Strukturierung (48) in der dritten Schicht (36) im wesentlichen gleich ist mit der Breite (l₄) der Öffnung (46), die Breite der Strukturierung (48) in der zweiten Schicht (34) größer ist als die Breite (l₄) der Öffnung (46), die Breite der Strukturierung (48) in der ersten Schicht (32) geringer ist als die Breite (l₄) der Öffnung (46);
Aufeinanderfolgendes Entwickeln der Strukturierung (48) in der dritten Schicht (36), der zweiten Schicht (34) und der ersten Schicht (32) zur Herstellung einer Öffnung (52) über die dritte, zweite und erste Schicht (32, 34, 36) bis zu dem Substrat (12), dadurch Herstellen eines strukturierten Substrates; und
Abscheiden eines Metalles (56) nach unten auf das strukturierte Substrat, dadurch Ausbilden einer T-Gatemetallstruktur.

2. Verfahren nach Anspruch 1, welches nach dem Schritt des Abscheidens von Metall (56) den weiteren Schritt aufweist:
Entfernen des verbleibenden Abschnittes der Schichten (32, 34, 36, 38) aus Fotolack-Polymermaterial.

3. Verfahren nach Anspruch 1 oder 2, wobei das Fotolack-Polymermaterial der ersten Schicht (32) Poly(methylmethacrylat) darstellt.

4. Verfahren nach einem der Ansprüche 1 bis 3, wobei das Fotolack-Polymermaterial in der zweiten Schicht (34) ein Ko-Polymer von Polymethacrylsäure in (Polymethylmethacrylat) darstellt.

5. Verfahren nach einem der Ansprüche 1 bis 4, wobei das Fotolack-Polymermaterial in der dritten Schicht (36) Polymethylmethacrylat darstellt.

6. Verfahren nach einem der Ansprüche 1 bis 5, wobei das Fotolack-Polymermaterial der vierten Schicht (38) ein Positiv-Fotolack-Polymermaterial darstellt.

7. Verfahren nach einem der vorhergehenden Ansprüche, wobei die Breite des Streifens in der vierten Schicht (38) im Bereich von 0,5 bis 0,8 Mikrometer liegt.

8. Verfahren nach einem der vorhergehenden Ansprüche, wobei die Wellenlänge der tiefen ultravioletten Strahlung etwa 220 Nanometer, und die Wellenlänge der ultravioletten Strahlung im mittleren Bereich etwa 400 Nanometer beträgt.

9. Verfahren nach einem der vorhergehenden Ansprüche, wobei die T-Gatemetallstruktur einen Fuß (28) in Kontakt mit dem Substrat (12) und einen vergrößerten Kopf (30) auf dem Fuß (28) und integriert mit dem Fuß gebildet aufweist, wobei
die erste Schicht (32) aus Positiv-Fotolack-Polymermaterial fotoempfindlich ist für ultraviolette Strahlung mit einer Wellenlänge von weniger als 300 Nanometer und entwickelbar ist in einem ersten Entwickler;
die zweite Schicht (34) aus Positiv-Fotolack-Polymermaterial fotoempfindlich ist für ultraviolette Strahlung mit einer Wellenlänge von weniger als 300 Nanometer und entwickelbar ist in einem zweiten Entwickler;
die dritte Schicht (36) aus Positiv-Fotolack-Polymermaterial fotoempfindlich ist für ultraviolette Strahlung mit einer Wellenlänge von weniger als 300 Nanometer und entwickelbar ist in einem Entwickler, der unterschiedlich ist zu dem zweiten Entwickler;
die vierte Schicht (38) aus Fotolack-Polymermaterial fotoempfindlich ist für ultraviolette Strahlung mit einer Wellenlänge von mehr als 350 Nanometer;
der Schritt der Belichtung des Streifens in der vierten Schicht (38) erfolgt unter Verwendung von ultravioletter Strahlung mit einer Wellenlänge von mehr als 350 Nanometer und Entwickeln des belichteten Bereiches, Herstellen der Öffnung (46) mit einer Breite (l₄) von weniger als 0,5 Mikrometer durch die vierte Schicht (38), und Ausheilen der oberen Oberfläche der dritten Schicht (36);
der Schritt der Belichtung der Strukturierung (48) in der ersten, zweiten, und dritten Schicht (32, 34, 36) durch die Öffnung (46) in der vierten Schicht (38) durchgeführt wird unter Verwendung der vierten Schicht (38) als eine Maske mit ultravioletter Strahlung mit einer Wellenlänge von weniger als 300 Nanometer; und die T-Gatemetallstruktur den Fuß (28) mit der Breite der Strukturierung in der ersten Schicht (32) und den Kopf (30) mit einer größeren Breite aufweist.

10. Verfahren nach einem der vorhergehenden Ansprüche, wobei die Dicke der ersten Schicht (32) etwa 0,3 Mikrometer, die Dicke der zweiten Schicht (34) etwa 0,3 Mikrometer, die Dicke der dritten Schicht (36) etwa 0,2 Mikrometer und die Dicke der vierten Schicht (38) etwa 0,5 Mikrometer beträgt.

11. Verfahren nach einem der vorhergehenden Ansprüche, wobei die T-Gatemetallstruktur Teil eines Feldeffekttransistors ist.

12. Verfahren nach einem der vorhergehenden Ansprüche, wobei eine Vielzahl von T-Gatemetallstrukturen gleichzeitig hergestellt wird.

## Revendications

1. Un procédé de formation d'une structure métallique de grille en T sur un substrat (12), comprenant les étapes suivantes :
on dépose sur le substrat (12) une première couche (32) d'un polymère consistant en une matière de réserve photosensible positive qui est photosensible à de la lumière dans l'ultraviolet lointain, et qui est développé dans un premier développateur;
on dépose sur la première couche (32) une seconde couche (34) d'un polymère consistant en une matière de réserve photosensible positive qui est photosensible à de la lumière dans l'ultraviolet lointain et qui est développé dans un second développateur;
on dépose sur la seconde couche (34) une troisième couche (36) d'un polymère consistant en une matière de réserve photosensible positive qui est photosensible à de la lumière dans l'ultraviolet lointain et qui est développé dans un développateur qui est différent du second développateur;
on dépose sur la troisième couche (36) une quatrième couche (38) d'un polymère consistant en une matière de réserve photosensible qui est photosensible à de la lumière dans l'ultraviolet moyen;
on expose un ruban dans la quatrième couche (38) en utilisant de la lumière dans l'ultraviolet moyen et on développe le ruban dans la quatrième couche (38), ce qui produit une ouverture (46) à travers la quatrième couche (38), jusqu'à la surface supérieure de la troisième couche (36);
on expose un motif (48) dans les première, deuxième et troisième couches (32, 34, 36), à travers l'ouverture (46) dans la quatrième couche (38), en utilisant la quatrième couche (38) à titre de masque, avec de la lumière dans l'ultraviolet lointain, la largeur du motif (48) dans la troisième couche (36) étant fondamentalement égale à la largeur (l₄) de l'ouverture (46), la largeur du motif (48) dans la seconde couche (34) étant supérieure à la largeur (l₄) de l'ouverture (46), et la largeur du motif (48) dans la première couche (32) étant inférieure à la largeur (l₄) de l'ouverture (46);
on développe séquentiellement le motif (48) dans la troisième couche (36), la seconde couche (34) et la première couche (32), pour produire une ouverture (52) à travers les troisième,deuxième et première couches (32, 34, 36), jusqu'au substrat (12), ce qui a pour effet de produire un substrat portant un motif; et
on dépose un métal (56) en direction descendante sur le substrat portant un motif, pour former ainsi une structure métallique de grille en T.

2. Le procédé de la revendication 1, comprenant, après l'étape de dépôt de métal (56), l'étape supplémentaire suivante :
on enlève la partie restante des couches (32, 34, 36, 38) de polymères consistant en matières de réserve photosensibles.

3. Le procédé de la revendication 1 ou 2, dans lequel le polymère consistant en matière de réserve photosensible dans la première couche (32) est du poly(méthacrylate de méthyle).

4. Le procédé de l'une des revendications 1-3, dans lequel le polymère consistant en une matière de réserve photosensible dans la deuxième couche (34) est un copolymère d'acide polyméthacrylique et de poly(méthacrylate de méthyle).

5. Le procédé de l'une des revendications 1-4, dans lequel le polymère consistant en une matière de réserve photosensible dans la troisième couche (36) est du poly(méthacrylate de méthyle).

6. Le procédé de l'une des revendications 1-5, dans lequel le polymère consistant en une matière de réserve photosensible de la quatrième couche (38) est une matière de réserve photosensible positive.

7. Le procédé de l'une quelconque des revendications précédentes, dans lequel la largeur du ruban dans la quatrième couche (38) est comprise entre 0,5 et 0,8 micromètre.

8. Le procédé de l'une quelconque des revendications précédentes, dans lequel la longueur d'onde de la lumière dans l'ultraviolet lointain est d'environ 220 nanomètres, et la longueur d'onde de la lumière dans l'ultraviolet moyen est d'environ 400 nanomètres.

9. Le procédé de l'une des revendications précédentes, dans lequel la structure métallique de grille en T (28) comporte un pied en contact avec le substrat (12) et une tête agrandie (30) qui se trouve sur le pied (28) et qui est formée d'un seul tenant avec ce dernier, et dans lequel
la première couche (32) de polymère consistant en une matière de réserve photosensible positive est photosensible à de la lumière ultraviolette ayant une longueur d'onde inférieure à environ 300 nanomètres, et elle peut être développée dans un premier développateur;
la deuxième couche (34) de polymère consistant en une matière de réserve photosensible positive est photosensible à de la lumière ultraviolette ayant une longueur d'onde inférieure à 300 nanomètres, et elle peut être développée dans un second développateur;
la troisième couche (36) de polymère consistant en une matière de réserve photosensible positive est photosensible à de la lumière ultraviolette ayant une longueur d'onde inférieure à 300 nanomètres, et elle peut être développée dans un développateur différent du second développateur;
la quatrième couche (38) de polymère consistant en une matière de réserve photosensible est photosensible à de la lumière ultraviolette ayant une longueur d'onde supérieure à 350 nanomètres;
l'étape d'exposition du ruban dans la quatrième couche (38) est effectuée en utilisant de la lumière ultraviolette ayant une longueur d'onde supérieure à 350 nanomètres, et en développant la région exposée, ce qui produit l'ouverture (46) ayant une largeur (l₄) inférieure à 0,5 micromètre à travers la quatrième couche (38), et révèle la surface supérieure de la troisième couche (36);
l'étape d'exposition du motif (48) dans les première, deuxième et troisième couches (32, 34, 36) à travers l'ouverture (46) dans la quatrième couche (38), est effectuée en utilisant la quatrième couche (38) à titre de masque, avec de la lumière ultraviolette ayant une longueur d'onde inférieure à 300 nanomètres; et
le pied (28) de la structure métallique de grille en T a la largeur du motif dans la première couche (32), et la tête (30) de cette structure a une plus grande largeur.

10. Le procédé de l'une des revendications précédentes, dans lequel l'épaisseur de la première couche (32) est d'environ 0,3 micromètre, l'épaisseur de la deuxième couche(34) est d'environ 0,3 micromètre, l'épaisseur de la troisième couche (36) est d'environ 0,2 micromètre et l'épaisseur de la quatrième couche (38) est d'environ 0,5 micromètre.

11. Le procédé de l'une des revendications précédentes, dans lequel la structure métallique de grille en T fait partie d'un transistor à effet de champ.

12. Le procédé de l'une quelconque des revendications précédentes, dans lequel on prépare simultanément un ensemble de structures métalliques de grille en T.
